# EUROPÄISCHE PATENTSCHRIFT

(11) **EP 1 379 463 B1**
(45) Veröffentlichungstag und Bekanntmachung des Hinweises auf die Patenterteilung: **02.08.2006**
(21) Anmeldenummer: 02712794.3
(22) Anmeldetag: 21.02.2002
(51) Int. Cl.: B81B 3/00, B81C 1/00, G01F 1/684, G01F 1/688, G01F 1/699

(54) **Verfahren zur Herstellung eines Halbleiterbauelementes sowie ein nach dem Verfahren hergestelltes Halbleiterbauelement**
Method for producing a semiconductor component and a semiconductor component produced according to this method
Procédé pour produire un composant à semi-conducteur et composant à semi-conducteur obtenu selon le procédé

(30) Priorität: 07.04.2001 DE 10117486
(43) Veröffentlichungstag der Anmeldung: 14.01.2004
(73) Patentinhaber: ROBERT BOSCH GMBH, 70442 Stuttgart (DE)
(72) Erfinder: BENZEL, Hubert, 72124 Pliezhausen (DE); WEBER, Heribert, 72622 Nuertingen (DE); SCHAEFER, Frank, 72070 Tuebingen (DE)
(86) Internationale Anmeldenummer: PCT/DE2002/000608
(87) Internationale Veröffentlichungsnummer: WO 2002/081363

(56) Entgegenhaltungen:
- WO-A-98/50763
- DE-A- 19 752 208
- DE-C- 19 518 371
- US-A- 4 680 963
- LANG W ET AL: "Porous silicon: A novel material for microsystems" SENSORS AND ACTUATORS A, ELSEVIER SEQUOIA S.A., LAUSANNE, CH, Bd. 51, Nr. 1, Oktober 1995 (1995-10), Seiten 31-36, XP004303552 ISSN: 0924-4247
- STEINER P ET AL: "MIKROSTRUKTURIERUNG MIT POROESEM SILIZIUM" ITG-FACHBERICHTE, VDE VERLAG, BERLIN, DE, Bd. 126, März 1994 (1994-03), Seiten 285-290, XP002900484 ISSN: 0932-6022

## Beschreibung

### Stand der Technik

Die Erfindung geht aus von einem Verfahren zur Herstellung eines Halbleiterbauelements, wie insbesondere ein mehrschichtiges Halbleiterbauelement, und von einem verfahrensgemäß hergestellten Halbleiterbauelement nach der Gattung des betreffenden unabhängigen Patentanspruchs.

Halbleiterbauelemente, wie insbesondere mikromechanische Wärmeleitsensoren, werden in der Regel in sogenannter Bulk- oder Oberflächenmikromechanik hergestellt. Die Herstellung von bulkmikromechanischen Bauelementen ist relativ aufwendig und damit teuer. Bei bekannten oberflächenmikromechanischen Bauelementen ist die Herstellung einer Kaverne aufwendig. Eine übliche Prozeßfolge zur Herstellung einer Kaverne in Oberflächenmikromechanik besteht insbesondere aus dem Abscheiden einer Opferschicht, dem Abscheiden einer Membranschicht, die meist aus Polysilizium besteht, dem Erzeugen von Öffnungen in der Membranschicht bzw. dem Öffnen eines lateralen Ätzkanals, dem Herausätzen der Opferschicht und dem Verschließen der Öffnungen, wobei beim Verschließen der Kaverneninnendruck definiert wird.

Aus der WO 98/50763 A1 ist ein Sensor zur Erfassung eines Gasflusses bekannt. Dieser Sensor weißt eine Membran oberhalb eines Substrats auf, wobei die Membran thermisch vom Substrat isoliert ist. Die thermische Isolierung wird dabei in einer Ausgestaltung durch eine Kaverne realisiert, die mittels des Herauslösens von zuvor im Substrat erzeugten porösen Silizium gebildet wird. Alternativ hierzu wird auch beschrieben, das poröse Silizium nicht herauszulösen sondern statt dessen zu oxidieren, um ebenfalls eine thermische Isolierung der Membran zu erhalten

Aus der 4,680,963 A ist ein Massenflusssensor bekannt, bei dem die Geschwindigkeit eines Massenflusses über den Sensor in Abhängigkeit von dem Wärmetransfer eines betriebenen Heizelements auf dem Sensor erfasst wird. Um den Wärmetransfer eindeutig auf den Massenfluss zurück führen zu können, wird das Heizelement mittels einer porösen und oxidierten Schicht vom Substrat thermisch isoliert.

Die DE 197 52 208 A1 beschreibt ein Verfahren zur Herstellung eines Membransensors. Dabei wird zunächst im Substrat in einem Oberflächenbereich poröses Silizium gebildet. Anschließend wird auf das poröse Silizium eine Membranschicht aufgebracht: Nach der Ausbildung von Schaltstrukturen auf der Membran wird das poröse Silizium entfernt, um die Membran thermisch vom Substrat zu entkoppeln.

### Vorteile der Erfindung

Das erfindungsgemäße Verfahren mit den kennzeichnenden Merkmalen des betreffenden unabhängigen Patentanspruchs hat demgegenüber insbesondere den Vorteil, daß ein mikromechanisches Bauelement, wie insbesondere ein Wärmeleitsensor mit Sensorelementen einfach und kostengünstig in Oberflächenmikromechanik hergestellt werden kann. Durch die in den abhängigen Patentansprüchen aufgeführten Maßnahmen sind vorteilhafte Weiterbildungen und Verbesserungen des Verfahrens und des Halbleiterbauelements nach den betreffenden unabhängigen Patentansprüchen ermöglicht.

Unter einem Wärmeleitsensor soll insbesondere ein Sensor zur Messung eines Luft- und/oder Gasstroms, eines Luftdrucks und/oder eines Gasdrucks anhand der an die Luft bzw. an das Gas, wie insbesondere Wasserstoff, abgegebenen Wärme verstanden werden.

Ein wichtiger Aspekt der Erfindung besteht darin, eine poröse Schicht in einem Halbleiterbauelement, beispielsweise ein Wärmeleitsensor, zu schaffen. Die poröse Schicht kann in einem Halbleitersubstrat, wie insbesondere in einem Siliziumsubstrat oder in einer auf dem Halbleitersubstrat abgeschiedenen Epitaxieschicht, beispielsweise eine Siliziumschicht, gebildet werden. Die kostengünstig herstellbare poröse Schicht dient insbesondere zur thermischen Isolierung des Halbleitersubstrats und/oder der Epitaxieschicht gegenüber einem in dem Halbleiterbauelement vorgesehenen Sensorbereich. Aufgrund der thermischen Isolierung wird ein Wärmefluß vom Sensorbereich an das Substrat und/oder die Epitaxieschicht stark verringert. Die Ansprechempfindlichkeit eines im Sensorbereich vorgesehenen Sensors wird erhöht und dessen Ansprechzeit verringert. Hierzu wird die Deckschicht des Substrats oder der Epitaxieschicht im Bereich der später erzeugten Sensorelemente derart geätzt, daß in dieser Öffnungen bzw. Ätzöffnungen, wie insbesondere Poren bzw. Hohlräume entstehen. Die Dicke und/oder Porosität der porösen Schicht kann mittels des nachfolgend erläuterten Ätzvorgangs je nach Bedarf eingestellt bzw. variiert werden. Beispielsweise liegt die Dicke der porösen Schicht im Bereich von etwa 2 bis 80 µm.

Ein weiterer wichtiger Aspekt der Erfindung besteht darin, im Bereich bzw. unter der porösen Schicht eine Kaverne bzw. einen Hohlraum in dem Halbleitersubstrat oder in der Epitaxieschicht mit einem Ätzmedium zu schaffen, um die thermische Isolierung bzw. Entkoppelung des Substrats und/oder der Epitaxieschicht gegenüber dem Sensorbereich weiter zu verbessern. Über die Ätzöffnungen bzw. nach außen offenen Poren der porösen Schicht gelangt das Ätzmedium oder ein oder mehrere weitere Ätzmedien an tiefere Bereiche des Substrats oder der Epitaxieschicht. Der in diesem Bereich von dem Ätzmedium bzw. von den weiteren Ätzmedien zersetzte Teil des Halbleitersubstrats bzw. der Epitaxieschicht wird bevorzugt über die Öffnungen bzw. Poren der Deckschicht und/oder über eine externe Zugangsöffnung zu diesem Bereich entfernt. Die oberhalb des Hohlraums bzw. der Kaverne befindliche poröse Schicht bzw. Deckschicht ist vorzugsweise dünn und zugleich ausreichend tragfähig gestaltet, damit weitere Schichten auf der porösen Schicht abgeschieden und strukturiert werden können. Die poröse Schicht oberhalb des Hohlraums weist bevorzugt eine Dicke von ca. 2 bis 10 µm, wie insbesondere 3 bis 5 µm, auf.

Bei einer bevorzugten Ausführungsform der Erfindung werden beim Ätzvorgang Maßnahmen ergriffen, die dafür sorgen, daß die Ausdehnungsgeschwindigkeit der Poren in der Deckschicht geringer, vorzugsweise deutlich geringer, als die Ausdehnungsgeschwindigkeit der Poren bzw. Hohlräume in dem Bereich des Substrats oder der Epitaxieschicht ist, der den späteren Hohlraum bzw. die Kaverne bildet.

Dies wird nach einer vorteilhaften Ausführungsform der Erfindung erreicht, indem die Ätzparameter und/oder das oder die Ätzmedien beim Ätzen der Poren in der Deckschicht und die Ätzparameter und/oder das oder die Ätzmedien beim Ätzen der Poren bzw. Hohlräume in dem Bereich der'späteren Kaverne unterschiedlich gewählt sind.

Hieran ist insbesondere vorteilhaft, daß die Porosität der Deckschicht zum Abtransport des zur Herstellung der Kaverne zu zersetzenden Siliziums in prozeßtechnisch gut kontrollierbarer Weise bevorzugt lediglich angemessen groß einstellbar ist. Andererseits kann die Kaverne jedoch schnell und damit kostengünstig hergestellt werden.

Nach einer bevorzugten Ausführungsform der Erfindung ist vorgesehen, die Ätzparameter derart einzustellen und/oder das oder die Ätzmedien beim Ätzen der Kaverne derart zu wählen, daß die Ausdehnungsgeschwindigkeit der Poren bzw. Hohlräume unterhalb der porösen Deckschicht derart hoch ist, daß die Poren bzw. Hohlräume sehr rasch miteinander "überlappen". Hierdurch entsteht zunächst ein einziger weitgehend flächenhafter Ausgangshohlraum im Substrat oder in der Epitaxieschicht, der sich mit fortschreitender Zeit in die Tiefe ausdehnt und die Kaverne bildet.

Bei einer bevorzugten, zur unmittelbar vorstehenden Ausführungsform alternativen Ausführungsform der Erfindung ist vorgesehen, die Ätzparameter und/oder das oder die Ätzmedien beim Ätzen der Kaverne derart zu wählen, daß die Porosität des Bereichs des Substrats oder der Epitaxieschicht, der die spätere Kaverne bildet, größer als die Porosität der Deckschicht ist. Bevorzugt weist die Vorstufe der späteren Kaverne eine Porosität von mehr als 70 % in bezug auf das Verhältnis des Volumens aller Hohlräume der Kaverne zu dem Volumen des nicht herausgeätzten Materials der Kaverne. Vorzugsweise wird die Kaverne nachfolgend aus dem porösen Bereich des Substrats oder der Epitaxieschicht unter Ausführung von einem oder mehreren Temperschritten, vorzugsweise über ca. 900 °C, gebildet.

Bei einer Temperung, bevorzugt unter einer Wasserstoff-, Stickstoff- oder Edelgasatmosphäre, wie bei Temperaturen über ca. 900 °C, ordnen sich die Poren im Bereich des Siliziums, der die spätere Kaverne bildet, bei einer Porosität von ca. mehr als 70 % um, wodurch unter der gering porösen Deckschicht eine einzelne große Pore, also ein Hohlraum bzw. eine Kaverne, entsteht. Die Poren auf der Oberseite der gering porösen Schicht werden bei diesem Hochtemperaturschritt weitgehend verschlossen, so daß auf der Deckschicht weitere Schichten, z. B. ein oder mehrere monokristalline Schichten, abgeschieden werden können.

Gemäß einer bevorzugten Ausführungsform der Erfindung handelt es sich bei dem Ätzmedium und/oder den Ätzmedien zur Erzeugung der Öffnungen und/oder Poren in der Deckschicht und/oder zur Erzeugung der Kaverne um Flußsäure (HF) oder um eine flüssige Mischung oder eine chemische Verbindung, die Flußsäure enthält.

Bei einer bevorzugten Ausführungsform der Erfindung wird dem Ätzmedium bzw. den Ätzmedien ein leicht flüchtiger Bestandteil, vorzugsweise ein Alkohol, wie z. B. Äthanol, und/oder gereinigtes Wasser zur Verdünnung des Ätzmediums bzw. der Ätzmedien beigegeben.

Äthanol reduziert die Oberflächenspannung eines mit ihm versehenen Ätzmediums, wodurch eine bessere Benetzung der Siliziumoberfläche und ein besseres Eindringen des Ätzmediums in geätzte Poren bzw. Öffnungen bzw. Hohlräume ermöglicht wird. Ferner sind die während des Ätzvorgangs entstehenden Blasen kleiner als ohne die Zugabe von Äthanol zum Ätzmedium und die Blasen können so besser durch die Poren der Deckschicht entweichen. Daher läßt sich die Porengröße und/oder die Porosität der Deckschicht in vorteilhafter Weise kleiner halten als ohne die Zugabe des Alkohols.

Bei einer weiteren bevorzugten Ausführungsform der Erfindung ist vorgesehen, die Öffnungen und/oder Poren in der Deckschicht und/oder im Bereich der späteren Kaverne mit einem elektrochemischen Verfahren, vorzugsweise unter Verwendung des vorgenannten Ätzmediums bzw. der vorgenannten Ätzmedien, zu erzeugen.

Ferner ist bei einer bevorzugten Ausführungsform der Erfindung unter Verwendung eines elektrochemischen Ätzverfahrens, vorzugsweise ein Ätzverfahren unter Verwendung von Flußsäure (HF), vorgesehen, die Ausdehnungsgeschwindigkeit der beim Ätzvorgang entstehenden Poren oder Hohlräume durch das Anlegen einer elektrischen Spannung und eines hierdurch hervorgerufenen elektrischen Stroms durch das Ätzmedium bzw. die Ätzmedien zu beeinflussen. Die Ausdehnungsgeschwindigkeit der Poren bzw. Hohlräume ist insbesondere abhängig von der Dotierung des zu ätzenden Siliziumsubstrats, der Stromdichte, ggf. der HF-Konzentration im Ätzmedium und der Temperatur. Es versteht sich, daß dies lediglich Beispiele relevanter Verfahrensparameter eines erfindungsgemäßen Ätzverfahrens sind.

Nach einer bevorzugten Ausführungsform der Erfindung wird das Ätzmedium, die HF-Konzentration im Ätzmedium und/oder die Dotierung des zu ätzenden Bereichs und/oder die Temperatur und ggf. weitere Prozeßparameter des Ätzverfahrens derart gewählt, daß sich der Ätzvorgang bzw. die Poren- bzw. Hohlraumbildung in geeigneter Weise einstellen und/oder mit dem Ausschalten der elektrischen Spannung abstellen läßt, vorzugsweise weitgehend abrupt.

Bei einem erfindungsgemäß bevorzugten elektrochemischen Ätzverfahren mit einem einzigen Ätzmedium und/oder mit zwei oder mehreren Ätzmedien wird in einem ersten Zeitraum, während dem sich das Ätzmedium im Bereich der Deckschicht befindet, eine erste, nicht notwendigerweise zeitlich konstante Stromdichte im Ätzmedium eingestellt. Während eines zweiten Zeitraums, zu dem sich das betreffende Ätzmedium im Bereich der zu schaffenden Kaverne befindet, wird bevorzugt eine zweite, nicht notwendigerweise zeitlich konstante Stromdichte eingestellt, die höher oder deutlich höher als die oder eine während des ersten Zeitraums eingestellte Stromdichte ist. Hierdurch wird die Kaverne oder ein Vorstadium der Kaverne durch Poren bzw. Hohlräume gebildet, deren Ausdehnungsgeschwindigkeit während des Ätzvorgangs der Kaverne höher oder deutlich höher als die Ausdehnungsgeschwindigkeit der Poren zur Herstellung der porösen Deckschicht ist. Bei einer weiteren bevorzugten Ausführungsform der Erfindung ist vorgesehen, den porös zu ätzenden Bereich der Deckfläche des Substrats oder der Epitaxieschicht vor dem Ätzvorgang mit einer Maskenschicht bzw. Stützschicht zu umgeben, die einen freien Zugang des Ätzmediums bzw. der Ätzmedien zu dem porös zu ätzenden Bereich gestattet bzw. gestatten und die die nicht porös zu ätzenden Bereiche der Deckfläche des Substrats oder der Epitaxieschicht gegen einen Ätzangriff abschirmt.

Gemäß einer bevorzugten Ausführungsform der Erfindung ist die Stützschicht dergestalt, daß sie den porös zu ätzenden Bereich bzw. die porös zu ätzende Schicht der Deckfläche während und nach dem Ätzen der Kaverne am nicht geätzten Teil des Substrats bzw. der Epitaxieschicht mechanisch fixiert.

Bei einer bevorzugten Ausführungsform der Erfindung wird die Stützschicht vor dem Ätzen des porös zu ätzenden Bereichs bzw. der zu ätzenden Schicht geschaffen, indem zumindest der nächst umliegende Bereich um die porös zu ätzende Schicht der Deckfläche eines p-dotierten Siliziumsubstrats mit einer n-Dotierung versehen wird. Hierdurch kann ein "Unterätzen" des Substrats insbesondere in dem Bereich weitgehend verhindert werden, in dem die porös geätzte Schicht mit dem Siliziumsubstrat mechanisch verbunden ist. Anderenfalls bestünde die Gefahr, insbesondere bei einer bevorzugt'dünnen porösen Schicht, daß diese sich vom Substrat ablöst. Zusätzlich kann eine Siliziumnitrid-Schicht als Maskierung und insbesondere zum Schutz gegen einen Ätzangriff von ggf. darunter liegenden elektronischen Schaltungen verwendet werden.

Alternativ oder ergänzend kann anstelle der n-Dotierung bzw. einer n-dotierten Schicht eine Metallschicht oder Metallmaske vorgesehen sein, die ebenfalls ein Unterätzen des Substrats oder der Epitaxieschicht weitgehend verhindert. Die Verwendung einer Metallschicht bzw. Metallmaske wird jedoch in der Regel nur dann zweckmäßig sein, wenn im Substrat bzw. in der Epitaxieschicht keine Schaltkreise vorgesehen werden sollen, da ansonsten im Substrat bzw. in der Epitaxieschicht auch nach dem Entfernen der Metallschicht bzw. Metallmaske verbleibende Metallatome die Funktion der Schaltkreise beeinträchtigen könnten.

Bei einer weiteren bevorzugten Ausführungsform der Erfindung ist vorgesehen, eine porös geätzte Deckschicht, wie insbesondere eine Siliziumschicht, vorzubehandeln, bevor auf diese weitere Schichten, vorzugsweise eine oder mehrere Siliziumschichten, aufgebracht bzw. abgeschieden werden. Die Vorbehandlung verfolgt das Ziel, die Poren in der porös geätzten Deckschicht ganz oder teilweise zu verschließen, um die Qualität der darauf aufgebrachten bzw. abgeschiedenen Siliziumschicht(en), falls erforderlich oder zweckmäßig, weiter zu verbessern.

Eine erfindungsgemäße Vorbehandlung kann in einer Temperung der porös geätzten Deckschicht bestehen, wobei die Temperung bei einer hohen Temperatur vorgenommen wird, beispielsweise bei einer Temperatur im Bereich von ca. 900 °C bis ca. 1200 °C. Bevorzugt erfolgt die Temperung unter einer Wasserstoff-, Stickstoff- und/oder einer Edelgasatmosphäre.

Alternativ oder ergänzend zur vorgenannten Vorbehandlung kann eine (geringfügige) Oxidierung der porös geätzten Siliziumschicht vorgesehen werden. Bevorzugt erfolgt die Oxidierung unter (geringfügiger) Zugabe von Sauerstoff in die Atmosphäre, der die poröse Deckschicht im Reaktor ausgesetzt ist, wobei die Oxidierung bevorzugt bei einer Temperatur im Bereich von etwa 400 °C bis 600 °C erfolgt. Unter geringfügig ist eine Oxidierung zu verstehen, die weitgehend lediglich die Poren der porös geätzten Deckschicht ganz oder teilweise verschließt und eine etwa netzartige Oxidstruktur bildet.

Gemäß einer bevorzugten Ausführungsform der Erfindung wird die gering poröse Schicht bzw. Deckschicht mit einem Ätzmedium geätzt, das eine Flußsäure-Konzentration (HF-Konzentration) im Bereich von ca. 20 % bis ca. 50 %, vorzugsweise ca. 30 % bis ca. 40 %, insbesondere ca. 33 %, aufweist.

Bei einer weiteren bevorzugten Ausführungsform der Erfindung, wird die poröse Schicht, die eine Vorstufe des späteren Hohlraums bzw. der Kaverne bildet, mit einem Ätzmedium geätzt, das eine Flußsäure-Konzentration (HF-Konzentration) im Bereich von ca. 0 % bis ca. 40 %, vorzugsweise ca. 5 % bis ca. 20 %, insbesondere weniger als ca. 20 %, aufweist. Bevorzugt besteht der verbleibende Teil des Ätzmediums, der nicht durch Flußsäure gebildet ist, weitgehend aus einem Alkohol, wie insbesondere Äthanol.

Um während eines vorgenannten erfindungsgemäßen Ätzschritts zur Bildung eines Hohlraums bzw. einer Kaverne eine hohe Ausdehnungsgeschwindigkeit der Poren bzw. Hohlräume in der zu zersetzenden Schicht zu erreichen, bei der die Poren bzw. Hohlräume sehr rasch miteinander "überlappen" und so eine einzige "Riesenpore" bilden, ist bei einer erfindungsgemäßen Ausführungsform der Erfindung ein erfindungsgemäßes Ätzmedium vorgesehen. Das erfindungsgemäße Ätzmedium weist eine Flußsäure-Konzentration (HF-Konzentration) im Bereich von ca. 0 % bis ca. 5 %, vorzugsweise ca. 1 % bis ca. 3 %, insbesondere weniger als ca. 5 % auf. Bevorzugt besteht der verbleibende Teil dieses Ätzmediums, der nicht durch Flußsäure gebildet ist, weitgehend aus einem Alkohol, wie insbesondere Äthanol, und/oder aus gereinigtem Wasser.

### Zeichnungen

Das erfindungsgemäße Verfahren zur Herstellung eines erfindungsgemäßen mehrschichtigen Halbleiterbauelements wird nachfolgend am Beispiel von Wärmeleitsensoren unter Verwendung von schematischen, nicht notwendigerweise maßstäblichen Zeichnungen näher erläutert, wobei gleiche Bezugszeichen gleiche oder gleichwirkende Schichten oder Teile bezeichnen. Es zeigt:
- Fig. 1: eine Vorstufe eines erfindungsgemäßen Wärmeleitsensors nach der Erzeugung einer ersten Siliziumschicht mit geringer Porosität in einem Siliziumsubstrat mit einer unter der ersten Siliziumschicht liegenden zweiten porösen Siliziumschicht mit demgegenüber hoher Porosität - im Querschnitt;
- Fig. 2: die in Fig. 1 dargestellte Vorstufe, nachdem die zweite Siliziumschicht mit hoher Porosität zu einem Hohlraum geworden ist - im Querschnitt;
- Fig. 3: eine Vorstufe einer zweiten Variante eines Wärmeleitsensors mit einer auf dem Siliziumsubstrat abgeschiedenen Epitaxieschicht - im Querschnitt;
- Fig. 4: einen auf der Basis der in den Figuren 1 oder 2 dargestellten Vorstufe hergestellten Wärmeleitsensor, der mit Sensorelementen versehen worden ist - im Querschnitt;
- Fig. 5: eine Vorstufe einer dritten Variante eines erfindungsgemäßen Wärmeleitsensors mit einer einzigen dicken porösen Schicht - im Querschnitt;
- Fig. 6: einen auf der Basis der in Fig. 5 dargestellten Vorstufe hergestellten Wärmeleitsensor, der mit Sensorelementen versehen worden ist - im Querschnitt; und
- Fig. 7: eine vierte Variante eines erfindungsgemäßen Wärmeleitsensors mit Sensorelementen, die zur Messung des Umgebungsdrucks vorgesehen sind - in Draufsicht.

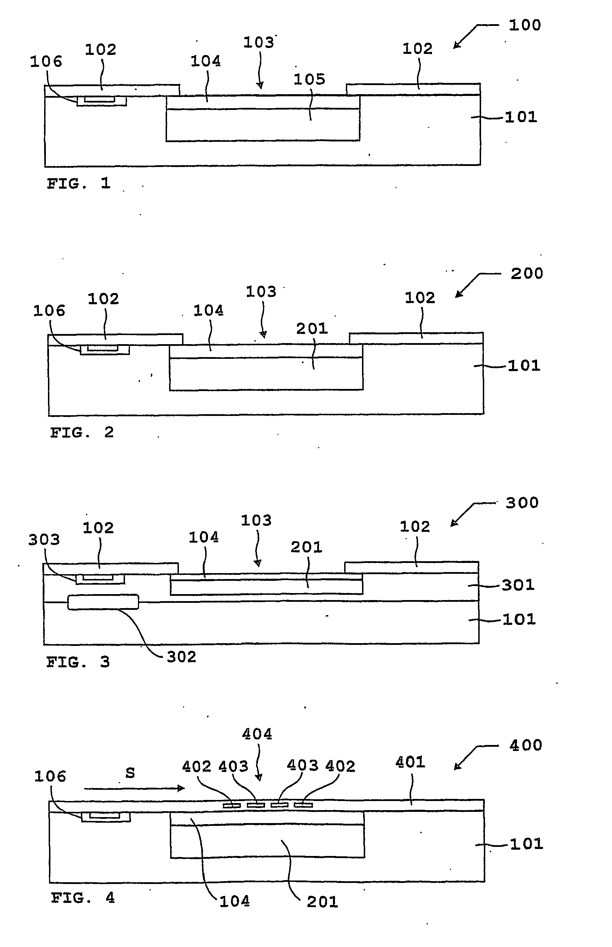

Fig. 1 zeigt eine Vorstufe 100 eines in Fig. 4 dargestellten Wärmeleitsensors 400 - im Querschnitt. Zur Herstellung des in Fig. 4 dargestellten Wärmeleitsensors 400 wird zunächst auf der Oberseite eines Siliziumsubstrats 101 eine Maskenschicht 102 erzeugt, wobei ein nicht durch die Maskenschicht 102 abgedeckter Bereich 103 entsteht. Bei der Maskenschicht kann es sich beispielsweise um eine Nitridschicht, eine n-dotierte Schicht (bei p-dotiertem Siliziumsubstrat) oder eine sonstige geeignete Schicht handeln, die von dem nachfolgend verwendeten Ätzmedium weitgehend nicht angegriffen wird. Eine an der Oberseite des Siliziumsubstrats befindliche integrierte Schaltung 106 wird durch die Maskenschicht 102 vor einem Ätzangriff ausreichend geschützt.

Die Oberseite des Siliziumsubstrats 101 wird elektrochemisch unter Verwendung eines geeigneten Ätzmediums derart geätzt, daß das Ätzmedium unmittelbar unter dem nicht abgedeckten Bereich 103 kleine Öffnungen bzw. Poren in dem Siliziumsubstrat 101 erzeugt. Es entsteht eine Siliziumschicht 104 mit geringer Porosität. Durch diese kleinen Öffnungen bzw. Poren der Siliziumschicht 104 gelangt das Ätzmedium in tiefer gelegene Bereiche des Siliziumsubstrats 101 und bildet ebenfalls Poren in dem dort befindlichen Silizium. Hierbei entsteht eine poröse Siliziumschicht 105 unterhalb der porösen Siliziumschicht 104. ,

Bei dem Ätzmedium zum elektrochemischen Ätzen, wie insbesondere Naßätzen, handelt es sich bevorzugt um Flußsäure (HF) oder um ein Ätzmedium, das u. a. Flußsäure (HF) enthält. Erfindungsgemäß wird bevorzugt ein elektrisches Feld zwischen der Oberseite und der Unterseite des Siliziumsubstrats 101 erzeugt, wobei über die eingestellte elektrische Feldstärke bzw. die eingestellte elektrische Stromdichte die Ausdehnungsgeschwindigkeit der Poren bzw. Öffnungen bzw. Hohlräume beeinflußt wird.

Bei einem bevorzugten elektrochemischen Ätzverfahren gemäß der Erfindung, werden zu ätzende Vorstufen der Wärmeleitsensoren in ein wannenförmiges Gefäß gegeben, das mit dem Ätzmedium gefüllt ist, und es wird eine elektrische Spannung derart an gegenüberliegenden Enden des Ätzmediums angelegt, daß das elektrische Feld entsteht.

Um dafür'zu sorgen, daß die poröse Siliziumschicht 104 im Bereich unmittelbar unter dem von der Maskenschicht 102 ausgesparten Bereich 103 entsteht, wird nach dem Aufbringen des Ätzmediums auf den nicht abgedeckten Bereich 103 in einem ersten Schritt eine nicht notwendigerweise konstante elektrische Stromdichte eingestellt. Sie ist vorzugsweise derart gewählt, daß unmittelbar unter dem nicht abgedeckten Bereich 103 Öffnungen bzw. Poren im Siliziumsubstrat 101 entstehen.

Ein weiteres, wichtiges Kriterium für die in dem ersten Schritt eingestellte, nicht notwendigerweise konstante elektrische Stromdichte besteht darin, eine solche elektrische Stromdichte einzustellen, bei der geeignete Öffnungen bzw. Poren im Siliziumsubstrat 101 unmittelbar unter dem nicht abgedeckten Bereich 103 entstehen. Geeignet sind insbesondere solche Öffnungen bzw. Poren, die es nachfolgend gestatten, auf der während des Ätzvorgangs gebildeten porösen Siliziumschicht 104 weitere Schichten, vorzugsweise Siliziumschichten abzuscheiden. Daher dürfen die Öffnungen bzw. Poren nur eine adäquate Größe bzw. einen adäquaten Durchmesser aufweisen. Bevorzugte Öffnungen bzw. Poren haben beispielsweise einen Durchmesser von ca. 10 bis 100 nm, vorzugsweise ca. 10-30 nm.

Es versteht sich, daß dies lediglich ein Beispiel für geeignete Öffnungen bzw. Poren ist.

Nachdem das Ätzmedium die poröse Siliziumschicht 104 durchdrungen hat, wird in einem zweiten Schritt bevorzugt die Stromdichte im Vergleich zur Stromdichte während des ersten Schritts erhöht, wodurch die Poren- bzw. Hohlraumausdehnungsgeschwindigkeit gesteigert wird und größere Poren in der Siliziumschicht 105 im Vergleich zu den Poren in der porösen Siliziumschicht 104 entstehen.

Das von dem Ätzmedium zersetzte Silizium wird während des Ätzvorgangs und/oder nachfolgend über die Öffnungen bzw. Poren in der porösen Siliziumschicht 104 entfernt und "frisches" Ätzmedium herangeführt.

Bei der in Fig. 1 dargestellten bevorzugten ersten Variante des erfindungsgemäßen Verfahrens zur Herstellung der Vorstufe eines Wärmeleitsensors bzw. eines Hohlraums, wird der Ätzvorgang zur Herstellung des späteren Hohlraums 201 (Fig. 2) durch die Wahl geeigneter Prozeßparameter und/oder eines oder mehrerer geeigneter Ätzmedien derart eingestellt, daß die Porosität der Siliziumschicht 105, die den späteren Hohlraum 201 bildet, ausreichend groß ist. Unter "ausreichend" wird bevorzugt eine Porosität verstanden, die größer als 70 Prozent und kleiner als 100 Prozent ist. Nachfolgend wird eine Temperung vorgenommen. Die Temperung erfolgt bevorzugt unter einer Wasserstoff-, Stickstoff- oder Edelgasatmosphäre und/oder bei einer Temperatur von über ca. 900 °C. Aufgrund der hohen Porosität der Siliziumschicht 105 ordnen sich bei der Temperung die Poren so um, daß unter der gering porösen Siliziumschicht 104 eine einzelne große Pore entsteht, also der in Fig. 2 dargestellte Hohlraum bzw. die dargestellte Kaverne 201. Die Poren auf der Oberseite der gering porösen Siliziumschicht 104 werden bei der Temperung bzw. dem Hochtemperaturschritt weitgehend verschlossen, so daß auf dieser weitere Schichten abgeschieden werden können.

Bei einer nicht dargestellten, ebenfalls bevorzugten erfindungsgemäßen zweiten Variante zur Erzeugung der Vorstufe eines Wärmeleitsensors bzw. eines Hohlraums 201 werden die Prozeßparameter nach der Bildung der Siliziumschicht 104 geringer Porosität derart eingestellt, daß die Ausdehnungsgeschwindigkeit der Poren bzw. Hohlräume innerhalb einer dünnen Übergangsschicht unter der Siliziumschicht 104 stark ansteigt, wobei die Poren in dieser Übergangsschicht zusammenwachsen bzw. einander quasi "überlappen". Mit anderen Worten: Die Übergangsschicht ist ein zunächst flächenhafter Hohlraum, der während des weiteren Ätzvorgangs in die Tiefe wächst und schließlich den Hohlraum bzw. die Kaverne 201 bildet. D. h. es werden nicht erst Poren geätzt und dann vergrößert, sondern die Übergangsschicht, eine flächenhafte "Riesenpore" mit zunächst geringer Dicke, wächst langsam in die Tiefe.

Erfindungsgemäß wird das Ätzmedium und/oder die Ätzmedien bevorzugt mit einem leicht flüchtigen Bestandteil versehen.

Vorzugsweise wird ein Alkohol verwendet, wie beispielsweise Äthanol.

Falls erforderlich oder zweckmäßig, ist erfindungsgemäß vorgesehen, den porös zu ätzenden Bereich der Deckfläche des Substrats 101 mit einer Maskenschicht und/oder Stützschicht zu versehen, die die porös zu ätzende Schicht der Deckfläche, d. h. die Siliziumschicht 104, während und nach dem Ätzen bzw. während der Schaffung des Hohlraums 201 an den Verbindungsstellen im Bereich der nicht geätzten Deckfläche des Substrats mechanisch fixiert (nicht dargestellt). Eine solche Stützschicht kann beispielsweise geschaffen werden, indem zumindest der nächst umliegende Bereich um die porös zu ätzende Siliziumschicht 104 der Deckfläche des p-dotierten Siliziumsubstrats 101 mit einer n-Dotierung versehen wird. Hiermit kann ein "Unterätzen" des Siliziumsubstrats 101 im Bereich der Verbindungsstellen bzw. Grenzflächen zwischen der Siliziumschicht 104 und dem Siliziumsubstrat 101 weitgehend verhindert werden. Ferner kann dafür Sorge getragen werden, daß auch eine bevorzugt dünne poröse Siliziumschicht 104 sicher am Siliziumsubstrat 101 befestigt ist.

Fig. 3 zeigt eine Vorstufe 300 einer zweiten Variante eines Wärmeleitsensors (nicht dargestellt) im Querschnitt. Die dargestellte Vorstufe 300 weist ein Siliziumsubstrat 101, eine auf dem Siliziumsubstrat 101 abgeschiedene Silizium-Epitaxieschicht 301 und eine auf der Oberseite der Silizium-Epitaxieschicht 301 aufgebrachte Maskenschicht 102 auf. Die Maskenschicht 102 weist einen die Silizium-Epitaxieschicht 301 nicht abdeckenden Bereich 103 auf. Ferner ist in der Oberseite der Silizium-Epitaxieschicht 301 und zwischen dem Siliziumsubstrat bzw. Wafer 101 und der Epitaxieschicht 301 jeweils eine integrierte Schaltung 303 bzw. 302 gebildet worden.

Mit dem vorstehend beschriebenen Verfahren wird in der Silizium-Epitaxieschicht 301 eine poröse Siliziumschicht 104 und ein darunter liegender Hohlraum bzw. eine Kaverne 201 im Bereich 103 erzeugt.

Beide Varianten der in den Figuren 1 bis 3 beschriebenen Wärmeleitsensoren weisen eine.poröse, tragfähige Deckschicht 104 über einem Hohlraum bzw. einer Kaverne 201 auf, so daß auf der Deckschicht weitere Schichten abgeschieden werden können. Die Dicke der porösen Deckschicht 104 beträgt etwa 2 bis 10 µm, vorzugsweise etwa 3 bis 5 µm. Zusätzlich können in die Deckschicht 104 eine oder mehrere definierte Öffnungen eingebracht werden, um einen Druckausgleich zwischen dem Hohlraum 201 und der Umgebung zu erreichen.

In Fig. 4 ist ein auf Basis der in den Fig. 1 oder 2 dargestellten Vorstufe hergestellter Wärmeleitsensor 400 im Querschnitt gezeigt. Nach der Entfernung der Maskenschicht 102 wird die poröse Siliziumschicht 104 durch die Abscheidung einer Verschlußschicht 401 oder durch Oxidation verschlossen. Der bei der Abscheidung der Verschlußschicht 401 bzw. bei der Oxidation herrschende Druck definiert den im Hohlraum bzw. der Kaverne 201 eingeschlossenen Druck. Die Dicke und Porosität der Siliziumschicht ist vorzugsweise derart bemessen, daß diese unter der Randbedingung einer möglichst geringen Wärmeleitfähigkeit bzw. möglichst guten thermischen Isolation des Sensorbereichs gegenüber dem Substrat eine ausreichende mechanische Stabilität aufweist. Vorzugsweise wird im Hohlraum bzw. in der Kaverne 201 ein gegenüber der Atmosphäre verminderter Druck, wie insbesondere Vakuum eingeschlossen, um eine bessere thermische Isolierung zwischen einem oberhalb der porösen Siliziumschicht 104 vorgesehenen Sensorbereich 404 und dem Siliziumsubstrat 101 zu erreichen. Hierdurch wird die Wärmeabgabe vom Sensorbereich an das Siliziumsubstrat 101 weiter verringert und damit eine höhere Ansprechempfindlichkeit bzw. Ansprechgeschwindigkeit von im Sensorbereich befindlichen Sensorelementen erreicht.

Befindet sich nach der Abscheidung der Verschlußschicht 401 Gas, beispielsweise Wasserstoff, im Hohlraum bzw. in der Kaverne 201, so kann dieses mit einem erfindungsgemäßen Hochtemperaturschritt, z.B. unter einer Stickstoffatmosphäre, weitgehend aus dem Hohlraum bzw. der Kaverne 201 entfernt werden. Der Wasserstoff diffundiert aufgrund seiner geringen Molekülgröße und aufgrund des Gradienten der Wasserstoffkonzentration insbesondere durch die im Verhältnis zum Substrat in der Regel dünnere Verschlußschicht 401.

Das gas- bzw. luftdichte Verschließen des Hohlraums bzw. der Kaverne 201 kann in einem Reaktor oder in einer Aufdampfanlage durchgeführt werden und braucht nicht notwendigerweise nach der Herstellung des Hohlraums bzw. der Kaverne 201 erfolgen, sondern kann als einer der letzten Verfahrensschritte ausgeführt werden. Dies hat den Vorteil, daß in der porösen Schicht 104 während der Prozessierung keine Wölbungen entstehen, die bei einem nachfolgenden optischen Strukturierungsprozeß (Lithographie) zu Abbildungsfehlern führen könnten.

Vor der Abscheidung der Verschlußschicht 401 kann die poröse Siliziumschicht 104 vorbehandelt werden. Eine bevorzugte erfindungsgemäße Vorbehandlung besteht aus einer Temperung der porösen Siliziumschicht 104. Bevorzugt wird die Temperung bei einer hohen Temperatur vorgenommen, wie beispielsweise bei einer Temperatur im Bereich von ca. 900 °C bis ca. 1200 °C und/oder die Temperung wird unter einer Wasserstoff-, Stickstoff- und/oder Edelgasatmosphäre vorgenommen.

Die Vorbehandlung erlaubt es, die Poren in der porös geätzten, monokristallinen Siliziumschicht 104 weitgehend zu verschließen, so daß auf dieser weitere Schichten, insbesondere Siliziumschichten, abgeschieden werden konnen. Es versteht sich, daß auf eine solche Vorbehandlung, insbesondere aus Kostengründen, verzichtet werden kann, wenn die Qualität der abgeschiedenen Siliziumschichten auch ohne Vorbehandlung zufriedenstellend ist.

Die Verschlußschicht 401 kann aus einer oder mehreren Siliziumoxid-, Siliziumnitrid-, Poly-Silizium- oder monokristallinen Silizium-Schichten gebildet sein. Durch das Abscheiden.unterschiedlicher Siliziumschichten, beispielsweise von Siliziumoxid- und Siliziumnitrid-Schichten wird in der Verschlußschicht 401 eine Zugspannung erzeugt, die der Druckdifferenz zwischen Membranoberseite und Membranunterseite entgegenwirkt, so daß durch die Druckdifferenz hervorrufbare Wölbungen in der Verschlußschicht 401 vermieden werden.

Auf der Verschlußschicht 401 bzw. auf der oxidierten Siliziumschicht 104 werden in dem Sensorbereich 404 über der porösen Siliziumschicht 104 Sensorelemente 402, 403 erzeugt, beispielsweise durch Abscheiden und Strukturieren von Metall, vorzugsweise von Platin. Alternativ kann die Erzeugung der Sensorelemente 402 und 403 beispielsweise durch die Abscheidung von Poly-Silizium auf der Verschlußschicht 401, eine nachfolgende Dotierung des abgeschiedenen Poly-Siliziums und ein anschließendes Strukturieren der abgeschiedenen Poly-Siliziumschicht erfolgen (nicht dargestellt). Ferner können die Sensorelemente 402 und 403 durch die Abscheidung einer Poly-Siliziumschicht und einem strukturierten Dotieren der Poly-Siliziumschicht erzeugt werden (nicht gezeigt). Die Sensorelemente 402 und 403 umfassen Widerstände, die als Temperaturfühler und als Heizelemente dienen, wobei die Temperaturfühler 402 im äußeren Sensorbereich 404 angeordnet sind und die Heizelemente 403 im inneren Sensorbereich positioniert sind. Vorzugsweise wird lediglich ein Heizelement 403 betrieben und das zweite Heizelement 403 dient als Reserve, wenn das erste Heizelement ausfällt. Ein Luft- oder Gasstrom, der in Strömungsrichtung S über die Oberfläche des Wärmeleitsensors 400 strömt, nimmt die von den Heizelementen 403 abgegebene Wärme auf, so daß sich zwischen den zwei Temperaturfühlern 402 ein Temperaturgradient bildet. Der Wärmeleitsensor 400 kann beispielsweise im Ansaugkanal eines Kraftfahrzeugs zur Messung und/oder Steuerung der zugeführten Verbrennungsluft vorgesehen sein. Anhand des Temperaturgradienten, der beispielsweise durch die integrierte Schaltung 106 ausgewertet wird, läßt sich die über den Wärmeleitsensor 400 strömende Luft- oder Gasmasse und deren Strömungsrichtung bestimmen.

Auf den Sensorelementen 402 und 403 können weitere Schichten aufgebracht und ggf. strukturiert werden. Beispielsweise können eine oder mehrere Siliziumnitridschichten abgeschieden werden, um die Sensorelemente 402 und 403 vor einem Eindringen von Feuchtigkeit zu schützen und/oder um die mechanische Stabilität der Sensorelemente 402 und 403 zu erhöhen. Die Dicke der auf den Sensorelementen 402 und 403 abgeschiedenen Schicht bzw. Schichten ist dabei bevorzugt so bemessen, daß eine ausreichende Ansprechempfindlichkeit der Sensorelemente 402 und 403 gewährleistet bleibt, d.h. die Wärmekapazität der Schicht bzw. der Schichten sollte möglichst gering sein.

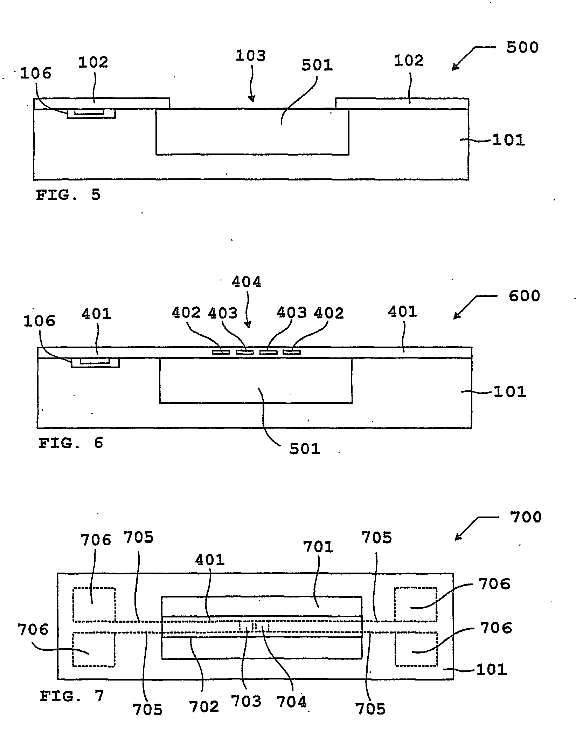

Fig. 5 zeigt eine Vorstufe 500 einer zweiten Variante eines erfindungsgemäßen Wärmeleitsensors 600 (Fig. 6) mit einer einzigen dicken porösen Schicht 501 im Querschnitt. Die dicke poröse Schicht 501 wird in analoger Weise wie insbesondere im Zusammenhang mit den Figuren 1 bis 3 erläutert erzeugt. Die poröse Schicht 501 ist jedoch vorzugsweise deutlich dicker als die gering poröse Schicht 104, wobei die Dicke der porösen Schicht 501 bevorzugt etwa 40 bis 80 µm, insbesondere etwa 50 bis 60 µm, beträgt. Im Unterschied zu den oben beschriebenen Wärmeleitsensoren ist die Bildung eines Hohlraums bzw. einer Kaverne 201 nicht vorgesehen. Die Porosität und/oder die Porengröße der porösen Schicht 501 kann mit dem oben beschriebenen Ätzverfahren optimiert werden, um die thermische Leitfähigkeit erheblich zu reduzieren. Beispielsweise kann die Porosität und/oder die Porengröße innerhalb der porösen Schicht 501 variieren. Vorzugweise ist die Porosität und/oder Porengröße im unteren, dem Substrat 101 zugewandten Bereich der porösen Schicht 501 größer als im oberen, dem Sensorbereich 404 zugewandten Bereich der porösen Schicht 501. Beispielsweise beträgt die Porosität im oberen Bereich der porösen Schicht 501 etwa bis zu maximal 20 % und im unteren Bereich der porösen Schicht 501 etwa bis zu maximal 80 %. Zusätzlich oder alternativ kann die dicke poröse Schicht 501 oxidiert werden, um die thermische Leitfähigkeit weiter herabzusetzen. Eine einzige dicke poröse Schicht 501 hat gegenüber einer Kombination aus einer dünnen porösen Schicht 104 und einer Kaverne 201 insbesondere den Vorteil einer höheren mechanischen Stabilität und in der Regel den Nachteil einer höheren Wärmeleitfähigkeit bzw. höheren Wärmeabgabe aus dem Sensorbereich an das Substrat.

In Fig. 6 ist ein auf der Basis der in Fig. 5 dargestellten Vorstufe hergestellter Wärmeleitsensor 600 im Querschnitt gezeigt. Nach der Entfernung der Maskenschicht 102 können eine oder mehrere Schichten auf der dicken porösen Schicht 501 abgeschieden und ggf. strukturiert werden, wobei ein luftdichtes Verschließen der porösen Schicht 501 vorgesehen sein kann. Bevorzugt wird auf der dicken porösen Schicht 501 eine Verschlußschicht 401 abgeschieden, die entsprechend dem Ausführungsbeispiel gemäß Fig. 4 eine oder mehrere Siliziumschichten, beispielsweise Siliziumoxid-, Siliziumnitrid-, Poly-Silizium- oder monokristalline Silizium-Schichten umfaßt. Auf der Verschlußschicht. 401 werden die Sensorelemente bzw. Widerstände 402 und 403 durch Abscheiden und Strukturieren von Metall, vorzugsweise von Platin, erzeugt. Auf den Sensorelementen 402 und 403 können weitere Schichten abgeschieden und strukturiert werden.

Der Wärmeleitsensor 600 ist entsprechend dem Wärmeleitsensor 400 gemäß Fig. 4 zur Messung von Luft- oder Gasmassen ausgelegt, so daß die Funktionsweise des Wärmeleitsensors 600 identisch ist mit der Funktionsweise des Wärmeleitsensors 400 gemäß Fig.4. Die Wärmeleitsensoren 400 und 600 finden bevorzugt Anwendung im Kraftfahrzeugbereich, insbesondere im Ansaugbereich von Kraftfahrzeugen, um die Ansaugströme zwecks Optimierung des Verbrennungsgemisches zu erfassen. Es sind jedoch auch sämtliche anderen Anwendungsbereiche denkbar, in denen Luft- oder Gasmassen bestimmt werden sollen.

Der Wärmeleitsensor 400 gemäß Fig. 4 weist aufgrund der porösen Schicht 104 sowie aufgrund der Bildung des Hohlraums bzw. der Kaverne 201 unterhalb der porösen Schicht 104 eine sehr gute thermische Isolierung des Sensorbereichs gegenüber dem Siliziumsubstrat auf, wohingegen der Wärmeleitsensor 600 gemäß Fig. 6 eine große mechanische Stabilität bei erhöhter Herstellungsausbeute besitzt. Insbesondere bei einer Positionierung des Wärmeleitsensors im Ansaugkanal ist dieser starken Luft- oder Gasströmen sowie einem "Beschuß" mit Partikeln ausgesetzt, so daß eine ausreichende mechanische Stabilität gewährleistet sein muß, um eine möglichst große Lebensdauer zu erzielen. Ferner wird durch die Bildung einer mechanisch ausreichend stabilen dicken porösen Schicht 501 mit vorzugsweise variierender Porosität und/oder Porengröße eine ausreichende thermische Isolierung erhalten, die eine zufriedenstellende Ansprechempfindlichkeit gewährleistet.

In Fig. 7 ist eine vierte Variante eines Wärmeleitsensors 700 in Draufsicht gezeigt, dessen Sensorelemente 703 und 704 zur Messung des Drucks eines den Sensor umgebenden Gases, wie z.B. Wasserstoff, vorgesehen sind. Mit dem vorstehend beschriebenen erfindungsgemäßen Verfahren wird in dem Siliziumsubstrat 101 eine poröse Siliziumschicht (nicht gezeigt) und ein darunter liegender Hohlraum bzw. eine Kaverne 701 erzeugt, wie dies in den Fig. 1 und 2 für die Vorstufen 100 und 200 des Wärmeleitsensors 400 dargestellt ist. Auf der porösen Schicht wird eine Verschlußschicht 401 abgeschieden, auf der Sensorelemente 703 und 704 erzeugt werden, entsprechend dem anhand Fig. 4 erläuterten Verfahren. Zusätzlich können ein oder mehrere integrierte Schaltungen zur Auswertung der Meßsignale vorgesehen sein. Die Sensorelemente 703 und 704 sind als Widerstände ausgebildet, wobei das Sensorelement 703 als Temperaturfühler und das Sensorelement 704 als Heizelement dient. Zusätzlich können ein oder mehrere Heizelemente vorgesehen sein (nicht dargestellt), um bei einer Beschädigung eines Heizelements auf ein anderes Heizelement umschalten zu können. Das Heizelement 704 und der Temperaturfühler 703 sind benachbart zueinander angeordnet und über Zuleitungen 705 mit Kontaktflächen 706 verbunden.

Im Betrieb wird das Heizelement 704 mittels elektrischem Strom erhitzt und der Temperaturfühler 703 mißt die Temperatur. Die von dem Heizelement an das den Sensor umgebende Gas abgegebene Wärme hängt von dessen Druck und dessen Art ab, d.h. je größer der Umgebungsdruck ist, desto höher ist die von dem Heizelement an das Gas abgegebene Wärmemenge. Anhand der Heizleistung, die erforderlich ist, um eine definierte bzw. konstante Temperatur zu halten, kann der Umgebungsdruck und/oder die Art bzw. Zusammensetzung des Gases bestimmt werden.

Um eine Wärmeableitung von dem Heizelement 704 in die Verschlußschicht 401 und in die poröse Schicht zu vermindern, ist die Verschlußschicht 401 und die poröse Schicht 104 seitlich von den Sensorelementen 703 und 704 zum Teil entfernt worden. Die poröse Schicht und die Verschlußschicht 401 bilden einen Steg 702 über dem einseitig offenen Hohlraum bzw. der Kaverne 701. Alternativ kann lediglich die Verschlußschicht 401 seitlich von den Sensorelementen 703 und 704 entfernt werden.

Alternativ kann entsprechend dem Ausführungsbeispiel, gemäß der Figuren 5 und 6 auf die Bildung eines Hohlraums bzw. einer Kaverne verzichtet werden und eine einzelne dicke poröse Schicht (nicht gezeigt) vorgesehen sein, di,e vorzugsweise oxidiert ist. Auf der dicken porösen Schicht wird eine Verschlußschicht 401 aufgebracht, die die poröse Schicht vollständig oder nur zum Teil, beispielsweise als Steg 702, überdeckt. Auf der Verschlußschicht 401 werden, wie vorstehend beschrieben, die Sensorelemente 703.und 704 erzeugt.

Auf den Sensorelementen 703 und 704 können - falls erforderlich - weitere Schichten abgeschieden und ggf. strukturiert werden.

### Bezugszeichenliste :

- 100: Vorstufe eines Wärmeleitsensors
- 101: Siliziumsubstrat
- 102: Maskenschicht
- 103: nicht abgedeckter Bereich
- 104: Siliziumschicht mit geringer Porosität
- 105: Siliziumschicht mit demgegenüber hoher Porosität
- 106: integrierte Schaltung

- 200: weitere Vorstufe eines Wärmeleitsensors
- 201: Hohlraum bzw. Kaverne

- 300: weitere Vorstufe eines Wärmeleitsensors
- 301: Silizium-Epitaxieschicht
- 302: integrierte Schaltung
- 303: integrierte Schaltung

- 400: Wärmeleitsensor
- 401: Verschlußschicht
- 402: Sensorelemente (Temperaturfühler)
- 403: Sensorelemente (Heizelemente)
- 404: Sensorbereich
- S: Strömungsrichtung

- 500: weitere Vorstufe eines Wärmeleitsensors
- 501: dicke poröse'Schicht

- 600: Wärmeleitsensor

- 700: Wärmeleitsensor, zur Druckbestimmung ausgebildet
- 701: einseitig offener Hohlraum
- 702: Steg
- 703: Sensorelement (Temperaturfühler)
- 704: Sensorelement (Heizelement)
- 705: Zuleitungen

- 706: Kontaktfläche

## Patentansprüche

1. Verfahren zur Herstellung eines Halbleiterbauelements (100; ...; 700), insbesondere ein mehrschichtiges Halbleiterbauelement, vorzugsweise ein mikromechanisches Bauelement, wie insbesondere ein Wärmeleitsensor, das
- ein Halbleitersubstrat (101), wie insbesondere aus Silizium, und
- einen Sensorbereich (404)
aufweist, wobei
- in einem ersten Schritt eine poröse Schicht (104; 501) gebildet wird, die den Sensorbereich (404) gegenüber dem Halbleitersubstrat (101) zumindest teilweise thermisch isoliert und
- in einem zweiten Schritt ein Hohlraum bzw. eine Kaverne (201; 701) unter der ersten porösen Schicht (104) in dem Halbleiterbauelement gebildet wird und
- der zweite Schritt einen ersten Unterschritt aufweist, während dem unter der ersten porösen Schicht (104) ein zunächst flächenhafter Hohlraum gebildet wird, und sich der zunächst flächenhafte Hohlraum in die Tiefe ausdehnt und so aus dem zunächst flächenhaften Hohlraum der Hohlraum bzw. die Kaverne (201; 701) entsteht.

2. Verfahren zur Herstellung eines Halbleiterbauelements (100; ...; 700), insbesondere ein mehrschichtiges Halbleiterbauelement, vorzugsweise ein mikromechanisches Bauelement, wie insbesondere ein Wärmeleitsensor, das
- ein Halbleitersubstrat (101), wie insbesondere aus Silizium, und
- einen Sensorbereich (404) aufweist, wobei
- in einem ersten Schritt eine poröse Schicht (104; 501) gebildet wird, die den Sensorbereich (404) gegenüber dem Halbleitersubstrat (101) zumindest teilweise thermisch isoliert und
- in einem zweiten Schritt ein Hohlraum bzw. eine Kaverne (201; 701) unter der ersten porösen Schicht (104) in dem Halbleiterbauelement gebildet wird und
- der zweite Schritt einen ersten Unterschritt aufweist, während dem unter der ersten porösen Schicht (104) eine zweite poröse Schicht (105) mit einer Porosität von mehr als ca. 70% und weniger als 100%, vorzugsweise ca. 80%, gebildet wird und
- der Hohlraum bzw. die Kaverne (201; 701) durch einen Temperschritt aus der zweiten porösen Schicht (105) gebildet wird.

3. Verfahren nach einem der Ansprüche 1 oder 2, **dadurch gekennzeichnet, dass** die erste und/oder zweite poröse Schicht (104,105) durch ein oder mehrere Ätzmedien gebildet wird bzw. gebildet werden, wobei das Ätzmedium und/oder die Ätzmedien vorzugsweise Flusssäure, HF-Säure, aufweisen oder aus Flusssäure bestehen.

4. Verfahren nach Anspruch 3, **dadurch gekennzeichnet, dass** das Ätzmedium bzw. die Ätzmedien mit einem oder mehreren Zusätzen versehen wird bzw. werden, wie Zusätzen
- zur Verringerung der Blasenbitdung,
- zur Verbesserung der Benetzung und/oder
- zur Verbesserung der Trocknung, wie insbesondere ein Alkohol, wie beispielsweise Äthanol
wobei die Volumenkonzeutration des Zusatzes, wie insbesondere Äthanol, bei Äthanol vorzugsweise ca. 30% bis ca. 80%, beträgt.

5. Verfahren nach einem der Ansprüche 1 bis 4, **dadurch gekennzeichnet dass** die erste und/oder zweite poröse Schicht (104, 105) unter Anlegen eines elektrischen Feldes zwischen der Oberseite und der Unterseite des Halbleiterbauelements (100; ... ; 700) und der Einstellung eines elektrischen Stroms gebildet wird.

6. Verfahren nach einem der Ansprüche 1 bis 5, **dadurch gekennzeichnet, dass** die Verfahrensparameter zur Bildung der zweiten porösen Schicht (105) bzw. zur Bildung des zunächst flächenhaften Hohlraums derart gewählt werden, dass die Ausdehnungsgeschwindigkeit der Poren bzw. Hohlräume in der zweiten porösen Schicht deutlich höher ist als die Ausdehnungsgeschwindigkeit der Poren bzw. Hohlräume zur Bildung der ersten porösen Schicht (104).

7. Verfahren nach einem der Ansprüche 1 oder 3 bis 6, **dadurch gekennzeichnet, dass** die Verfahrensparameter zur Bildung des zunächst flächenhaften Hohlraums derart gewählt werden, dass die Poren bzw. Hohlräume der zweiten porösen Schicht (105) einander in lateraler Richtung "überlappen" und so eine einzige zunächst flächenhafte Pore bzw. ein einziger zunächst flächenhafter Hohlraum gebildet wird.

8. Verfahren nach einem der Ansprüche 3 bis 7, **dadurch gekennzeichnet, dass** die Dotierung des zu ätzenden Halbleitersubstrats (101), wie insbesondere ein Siliziumsubstrat, die Stromdichte in dem Ätzmedium bzw. in den Ätzmedien, die Flasssäure-Konzentration in dem Ätzmedium bzw. in den Ätzmedien, ein oder mehrere Zusätze zum Ätzmedium bzw. zu den Ätzmedien und die Temperatur Verfahrensparameter darstellen.

9. Verfahren nach einem der Ansprüche 1 bis 8, **dadurch gekennzeichnet, dass** in der Kaverne bzw. im Hohlraum (201) eingeschlossener Wasserstoff im Rahmen eines Hochtemperatur aus der Kaverne bzw. dem Hohlraum weitgehend ganz oder teilweise entfernt wird.

10. Halbleiterbauelement (100; 200; 300; 400; 700), hergestellt nach einem der Ansprüche 1 bis 9, **dadurch gekennzeichnet, dass** als Halbleiterbauelement insbesondere ein mehrschichtiges Halbleiterbauelement, vorzugsweise ein mikromechanisches Bauelement, wie insbesondere ein Wärmeleitsensor, vorgesehen ist, welches
- ein Halbleitersubstrat (101), wie insbesondere aus Silizium, und
- einen Sensorbereich (404) und
- eine monokristalline poröse Schicht (104; 501), die den Sensorbereich (404) gegenüber dem Halbleitersubstrat (101) zumindest teilweise thermisch isoliert, und
- eine unter der monokristallinen porösen Schicht (104; 501) befindliche Kaverne
aufweist.

11. Halbleiterbauelement (100;...;700), insbesondere nach Anspruch 10,
wobei vorgesehen ist, dass auf der porösen Schicht (104; 501) eine Verschlussschicht (401) aufgebracht ist,
wobei
- die Verschlussschicht (401) vorzugsweise eine oder mehrere Siliziumschichten, beispielsweise Siliziumoxid-, Siliziumnitrid- und/oder dergleichen Siliziumschichten, umfasst, und
- die Schichtenfolge bzw. der Schichtaufbau der Verschlussschicht (401) derart gewählt bzw. gestaltet ist, dass sich eine Zugspannung in der Venchlussschicht (401) zum zumindest teilweisen Ausgleich eines Druckgradienten zwischen der Oberseite und der Unterseite der Verschlussschicht einstellt.

## Claims

1. Process for producing a semiconductor component (100; ...; 700), in particular a multilayer semiconductor component, preferably a micromechanical component, such as in particular a thermal conduction sensor, which includes
- a semiconductor substrate (101), such as in particular made from silicon, and
- a sensor region (404),
wherein
- in a first step, a porous layer (104; 501), which at least partially thermally insulates the sensor region (404) with respect to the semiconductor substrate (101), is formed, and
- in a second step, a void or cavity (201; 701) is formed in the semiconductor component beneath the first porous layer (104), and
- the second step includes a first substep, during which an initially superficial void is formed beneath the first porous layer (104), and the initially superficial void expands into the depth and in this way the void or cavity (201; 701) is formed from the initially superficial void.

2. Process for producing a semiconductor component (100; ...; 700), in particular a multilayer semiconductor component, preferably a micromechanical component, such as in particular a thermal conduction sensor, which includes
- a semiconductor substrate (101), such as in particular made from silicon, and
- a sensor region (404),
wherein
- in a first step, a porous layer (104; 501), which at least partially thermally insulates the sensor region (404) with respect to the semiconductor substrate (101), is formed, and
- in a second step, a void or cavity (201; 701) is formed in the semiconductor component beneath the first porous layer (104), and
- the second step includes a first substep, during which a second porous layer (105) with a porosity of more than approx. 70% and less than 10,0%, preferably approx. 80%, is formed beneath the first porous layer (104), and
- the void or cavity (201; 701) is formed from the second porous layer (105) by a conditioning step.

3. Process according to either of Claims 1 and 2, **characterized in that** the first and/or second porous layer (104, 105) is/are formed by one or more etching media, the etching medium and/or the etching media preferably including hydrofluoric acid, HF acid, or consisting of hydrofluoric acid.

4. Process according to Claim 3, **characterized in that** the etching medium or etching media is/are provided with one or more additives, such as additives
- for reducing the formation of bubbles,
- for improving the wetting and/or
- for improving the drying, such as in particular an alcohol, such as for example ethanol, the concentration by volume of the additive, such as in particular ethanol, being preferably approx. 30% to approx. 80% in the case of ethanol.

5. Process according to one of Claims 1 to 4, **characterized in that** the first and/or second porous layer (104, 105) is formed with the application of an electric field between the top side and the underside of the semiconductor component (100; ...; 700) and the setting of an electric current.

6. Process according to one of Claims 1. to 5, **characterized in that** the process parameters used to form the second porous layer (105) and/or to form the initially superficial void are selected in such a manner that the expansion rate of the pores or voids in the second porous layer is significantly higher than the expansion rate of the pores or voids used to form the first porous layer (104).

7. Process according to one of Claims 1 or 3 to 6, **characterized in that** the process parameters used to form the initially superficial void are selected in such a manner that the pores or voids of the second porous layer (105) "overlap" one another in the lateral direction, and in this way a single, initially superficial pore or a single, initially superficial void is formed.

8. Process according to one of Claims 3 to 7, **characterized in that** the doping of the semiconductor substrate (101) that is to be etched, such as in particular a silicon substrate, the current density in the etching medium or etching media, the hydrofluoric acid concentration in the etching medium or etching media, one or more additives to the etching medium or etching media and the temperature represent process parameters.

9. Process according to one of Claims 1 to 8, **characterized in that** hydrogen enclosed in the cavity or void (201) is substantially completely or partially removed from the cavity or void within a high temperature.

10. Semiconductor component (100; 200; 300; 400; 700), produced according to one of Claims 1 to 9, **characterized in that** the semiconductor component provided is in particular a multilayer semiconductor component, preferably a micromechanical component, such as in particular a thermal conduction sensor, which includes
- a semiconductor substrate (101), such as in particular made from silicon, and
- a sensor region (404), and
- a monocrystalline porous layer (104; 501) which at least partially thermally insulates the sensor region (404) with respect to the semiconductor substrate (101), and
- a cavity located beneath the monocrystalline porous layer (104; 501).

11. Semiconductor component (100; ...; 700), in particular according to Claim 10, in which it is provided that a closure layer (401) is applied to the porous layer (104; 501),
wherein
- the closure layer (401) preferably comprises one or more silicon layers, for example silicon oxide, silicon nitride and/or similar silicon layers, and
- the layer sequence or layer structure of the closure layer (401) is selected or configured in such a manner that a tensile stress is established in the closure layer (401) to at least partially compensate for a pressure gradient between the top side and the underside of the closure layer.

## Revendications

1. Procédé pour fabriquer un composant à semi-conducteur (100 ; ... ; 700), en particulier un composant à semi-conducteur à plusieurs couches, de préférence un composant micromécanique tel que notamment un détecteur de conduction thermique, présentant
- un substrat semi-conducteur (101), notamment en silicium, et
- une zone de détection (404),
selon lequel
- dans une première étape on forme une couche poreuse (104 ; 501) qui isole au moins partiellement, du point de vue thermique, la zone de détection (404) vis-à-vis du substrat semi-conducteur (101),
- dans une seconde étape, on forme un espace creux ou cavité (201 ; 701) sous la première couche poreuse (104) dans le composant à semi-conducteur, et
- la seconde étape comporte une première sous-étape au cours de laquelle un espace creux d'abord superficiel est formé sous la première couche poreuse (104) et cet espace d'abord superficiel va s'étendre en profondeur, de sorte qu'il se transforme en espace creux ou cavité (201 ; 701).

2. Procédé pour fabriquer un composant à semi-conducteur (100 ; ... ; 700), en particulier un composant à semi-conducteur à plusieurs couches, de préférence un composant micromécanique tel que notamment un détecteur de conduction thermique, présentant
- un substrat semi-conducteur (101), notamment en silicium, et
- une zone de détection (404),
selon lequel
- on forme dans une première étape, une couche poreuse (104 ; 501) qui isole au moins partiellement, du point de vue thermique, la zone de détection (404) vis-à-vis du substrat semi-conducteur (101)
- dans une seconde étape on forme un espace creux ou cavité (201 ; 701) sous la première couche poreuse (104) dans le composant à semi-conducteur, et
- la seconde étape comporte une première sous-étape au cours de laquelle une seconde couche poreuse (105), présentant une porosité de plus d'environ 70 % et de moins de 100 %, de préférence d'environ 80 %, est formée en dessous de la première couche poreuse (104) et
- l'espace creux ou cavité (201 ; 701) est formé par une opération de malléabilisation, à partir de la seconde couche poreuse (105).

3. Procédé selon l'une quelconque des revendications 1 ou 2,
**caractérisé en ce que**
la première et/ou la seconde couche poreuse (104, 105) est formée d'un ou plusieurs agents de gravure qui, de préférence, contiennent de l'acide fluorhydrique (acide HF) ou se composent d'acide fluorhydrique..

4. Procédé selon la revendication 3,
**caractérisé en ce que**
l'agent caustique (ou les agents) de gravure est pourvu (sont pourvus) d'un ou plusieurs additifs, notamment d'additifs servant à
- réduire la formation de bulles,
- améliorer l'humidification et/ou
- améliorer le séchage,
tels que notamment un alcool, par exemple l'éthanol, la concentration en volume de l'additif allant, dans le cas de l'éthanol, de préférence d'environ 30 % à environ 80 %.

5. Procédé selon l'une quelconque des revendications 1 à 4,
**caractérisé en ce que**
la première et/ou la seconde couche poreuse (104, 105) est formée en appliquant un champ électrique entre le côté supérieur et le côté inférieur du composant à semi-conducteur (100 ; ... ; 700) et en établissant un courant électrique.

6. Procédé selon l'une quelconque des revendications 1 à 5,
**caractérisé en ce que**
les paramètres du procédé pour la formation de la seconde couche poreuse (105), ou encore pour la formation de l'espace creux d'abord superficiel, sont choisis de telle manière que la vitesse d'expansion des pores ou espaces creux dans la seconde couche poreuse est nettement plus élevée que la vitesse d'expansion des pores ou espaces creux pour la formation de la première couche poreuse.

7. Procédé selon l'une quelconque des revendications 1 ou 3 à 6,
**caractérisé en ce que**
les paramètres du procédé pour la formation de l'espace creux d'abord superficiel sont choisis de telle manière que les pores ou espaces creux de la seconde couche poreuse (105) se "chevauchent" dans la direction latérale, et ainsi ne se forme qu'un seul pore d'abord superficiel ou un seul espace d'abord superficiel.

8. Procédé selon l'une quelconque des revendications 3 à 7,
**caractérisé en ce que**
le dopage du substrat semi-conducteur à décaper (101), notamment un substrat de silicium, la densité de courant dans l'agent caustique (ou les agents) de gravure, la concentration d'acide fluorhydrique dans l'agent (ou les agents) de gravure, un ou plusieurs additifs ajoutés à l'agent (ou aux agents) de gravure et la température représentent des paramètres du procédé.

9. Procédé selon l'une quelconque des revendications 1 ou 2,
**caractérisé en ce que**
de l'hydrogène enfermé dans la cavité ou espace creux (201) est évacué de cette cavité ou espace creux, dans le cadre d'un processus à haute température, entièrement ou partiellement.

10. Composant à semi-conducteur (100 ; 200 ; 300 ; 400 ; 700), produit selon l'une quelconque des revendications 1 à 9,
**caractérisé en ce qu'**
en tant que composant à semi-conducteur, on prévoit en particulier un composant à semi-conducteur à plusieurs couches, de préférence un composant micromécanique tel que notamment un détecteur de conduction thermique, lequel présente
- un substrat semi-conducteur (101), notamment silicium, et
- une zone de détection (404), et
- une couche poreuse monocristalline (104 ; 501) qui isole du point de vue thermique, au moins en partie, la zone de détection (404) vis-à-vis du substrat semi-conducteur (101), et
- une cavité se trouvant sous la couche poreuse monocristalline (104 ; 501).

11. Composant à semi-conducteur (100; 200 ; 300 ; 400 ; 700), en particulier selon la revendication 10, dans lequel on prévoit qu'une couche de fermeture (401) soit appliquée sur la couche poreuse (104 ; 501),
- la couche de fermeture (401) comprenant de préférence une ou plusieurs couches de silicium, par exemple des couches d'oxyde de silicium, de nitrure de silicium et/ou de substances similaires à base de silicium, et
- la séquence de couches ou la structure de couches de la couche de fermeture (401) étant choisie ou configurée de telle manière qu'une contrainte de traction s'établit dans la couche de fermeture (401), ce qui permet de compenser au moins en partie un gradient de pression entre le côté supérieur et le côté inférieur de cette couche de fermeture.
